**Europäisches Patentamt**

**European Patent Office**

**Office européen des brevets**

(19)

(11) Veröffentlichungsnummer: **0 106 059**
**B1**

(12) **EUROPÄISCHE PATENTSCHRIFT**

(45) Veröffentlichungstag der Patentschrift:
25.11.87

(51) Int. Cl.⁴: **H 03 K 17/73, H 01 L 29/74**

(21) Anmeldenummer: **83107965.2**

(22) Anmeldetag: **11.08.83**

(54) **Halbleiterschalter mit einem abschaltbaren Thyristor.**

(30) Priorität: **18.08.82 DE 3230741**

(43) Veröffentlichungstag der Anmeldung:
**25.04.84 Patentblatt 84/17**

(45) Bekanntmachung des Hinweises auf die Patenterteilung:
**25.11.87 Patentblatt 87/48**

(84) Benannte Vertragsstaaten:
**CH DE FR GB LI NL SE**

(56) Entgegenhaltungen:
**EP-A-0 062 099**
**EP-A-0 062 100**
**EP-A-0 064 717**
**DE-A-1 952 576**
**DE-B-2 625 917**
**US-A-4 284 911**

**ELECTRONIC COMPONENTS AND APPLICATIONS,** Band 3, Nr. 4, August 1981, Eindhoven F.J. BURGUM "Basic GTO drive circuits" Seiten 232-237
**Patent Abstracts of Japan** Band 2, Nr. 141, 22. November 1978 Seite 8847E78 & JP-A-53-108760
**ELEKTROTECHNISCHE ZEITSCHRIFT,** Band 102, Nr. 17, August 1981, Berlin D. SCHRÖDER "Neue Bauelemente der Leistungselektronik" Seiten 906-909

(73) Patentinhaber: **Siemens Aktiengesellschaft Berlin und München, Wittelsbacherplatz 2, D-8000 München 2 (DE)**

(72) Erfinder: **Herberg, Helmut, Dr., Bruderhofstrasse 30 a, D-8000 München 70 (DE)**

## Beschreibung

Die Erfindung bezieht sich auf ein Verfahren zum Betrieb eines Halbleiterschalters nach dem Oberbegriff des Patentanspruchs 1 und auf einen Halbleiterschalter zur Durchführung des Verfahrens.

Ein Verfahren dieser Art ist aus der DE-A-19 52 576, vgl. insbesondere Fig. 2 und zugehörigen Text, bekannt. Dabei werden im blockierten Zustand des abschaltbaren Thyristors, in welchem er über den Lastkreis in Durchlaßrichtung vorgespannt ist, aber noch nicht gezündet hat, die beiden Schalttransistoren so betrieben, daß sich der erste im gesperrten Zustand und der zweite im leitenden Zustand befindet. Dabei können aber die Schalttransistoren für den blockierten Thyristor keine stabilisierende Wirkung entfalten, d.h. ungewollte Zündungen desselben insbesondere bei schnell ansteigender Blockierspannung verhindern oder erschweren.

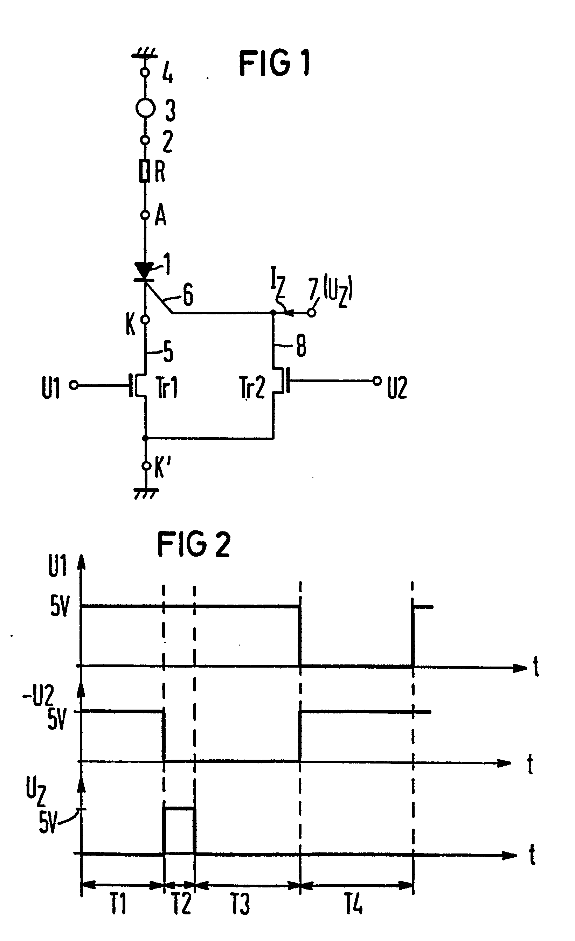

> Ein Halbleiterschalter mit einem abschaltbaren Thyristor, einem in dessen Zuleitung liegenden ersten Schalttransistor und einem in einen Abschaltstrompfad eingefügten zweiten Schalttransistor ist aus der Philips Technical Publication 029 "Electronic Components and Applications", Vol. 3, No. 4, August 1981, Seiten 232 bis 237, insbesondere Fig. 2, bekannt. Der in die Kathodenzuleitung des Thyristors eingefügte Schalttransistor ist hierbei als ein MOS-FET ausgebildet, über dessen Gate der Halbleiterschalter angesteuert wird. In den Abschaltstrompfad ist ein Kondensator eingefügt. Dieser wird mit einer Spannung aufgeladen, die den im blockierten Zustand befindlichen Thyristor zur Zündung vorbereitet. Wird nun der vorher gesperrte Schalttransistor in den leitenden Zustand gebracht, so schließt sich ein den Kondensator enthaltender Zündstromkreis, und der Thyristor wird gezündet. Beim Abschalten der Steuerspannung vom Gate des Schalttransistors wird dieser gesperrt, wodurch der Laststrom des Thyristors zur Gänze in den Abschaltstrompfad geleitet wird, und zwar so lange, bis der genannte Kondensator und ein weiterer, diesem über eine Diode parallel geschalteter Kondensator auf die genannte Spannung aufgeladen sind. Der Thyristor wird hierbei gelöscht.

Aus der DE-B-26 25 917 ist ein Thyristor bekannt, der einen Mehrschichtenhalbleiterkörper mit einer mehrteiligen n(p)-Emitterschicht, einer angrenzenden p(n)-Basisschicht, einer an diese angrenzende n(p)-Basisschicht und einer auf diese folgenden p(n)-Emitterschicht aufweist. Randseitig zu der mehrteiligen Emitterschicht sind jeweils als Feldeffekttransistoren ausgebildete, steuerbare Emitter-Basis-Kurzschlüsse vorgesehen, die eine wahlweise Wirksamschaltung von Inversionskanälen erlauben, welche niederohmige Verbindungen zwischen der mehrteiligen Emitterschicht und der an diese angrenzenden Basisschicht darstellen. Die Inversionskanäle können insbesondere zum schnellen Abschalten des Thyristors wirksam geschaltet werden, wobei ein hinreichend großer Teil des fließenden Laststroms über die Inversionskanäle und unter Umgehung der pn-Übergänge zwischen der mehrteiligen Emitterschicht und der angrenzenden Basisschicht abgeleitet wird. Die steuerbaren Emitter-Basis-Kurzschlüsse entsprechen dabei einem zweiten Schalttransistor, über den ein Abschaltstrompfad verläuft. Allerdings ist hier kein erster Schalttransistor vorgesehen, der in die Zuleitung des Thyristors eingefügt ist und im leitenden Zustand des letzteren den Laststrom aufnimmt.

Gegenstand der gemäß Artikel 54(3) zu berücksichtigenden EP-A2-00 64 717 ist ein Thyristor mit verbessertem Schaltverhalten, bei dem gategesteuerte, als MIS-Strukturen ausgebildete Emitterkurzschlüsse vorgesehen sind. Von diesen wird ein erster Teil nur für die Dauer des Zündvorgangs unwirksam geschaltet (Stabilisierungskurzschlüsse) und ein zweiter, größerer Teil nur während des Löschens wirksam geschaltet (Löschkurzschlüsse). Die Löschkurzschlüsse entsprechen in ihrer Gesamtheit einem zweiten Schalttransistor, über den ein Abschaltstrompfad verläuft. Jedoch fehlt auch hier ein in die Zuleitung des Thyristors eingefügter, erster Schalttransistor, der im leitenden Zustand des letzteren den Laststrom übernimmt.

Der Erfindung liegt die Aufgabe zugrunde, ein Verfahren der eingangs genannten Art anzugeben, bei dem die Stabilität des Halbleiterschalters, d.h. seine Sicherheit gegenüber unbeabsichtigten Zündungen des Thyristors beim Anlegen einer diesen in Durchlaßrichtung polenden Spannung, möglichst zu erhöhen. Das wird erfindungsgemäß durch die im kennzeichnenden Teil des Anspruchs 1 aufgeführten Merkmale erreicht.

Der mit der Erfindung erzielbare Vorteil besteht insbesondere darin, daß der zweite Schalttransistor einerseits die Funktion des Abschaltstrompfades voll aufrechterhält und andererseits im blockierten Zustand des Thyristors, in dem er gleichzeitig mit dem ersten Schalttransistor leitet, einen Emitter-Basis-Kurzschluß darstellt. Hierdurch wird die kritische Spannungsanstiegsgeschwindigkeit dU/dt, bis zu der eine unerwünschte Zündung des Thyristors durch eine den Thyristor in Durchlaßrichtung polende Spannung U sicher vermieden wird, gegenüber den bekannten Halbleiterschaltungen dieser Art ganz wesentlich erhöht.

Die Ansprüche 2 bis 8 sind auf bevorzugte Halbleiterschalter zur Durchführung des Verfahrens nach der Erfindung gerichtet.

Die Erfindung wird nachfolgend anhand der Zeichnung näher erläutert. Dabei zeigt:

Fig. 1 einen Halbleiterschalter, an dem das erfindungsgemäße Verfahren erklärt wird,

Fig. 2 Spannungs-Zeit-Diagramme zur weiteren Erläuterung des Verfahrens nach der Erfindung und

Fig. 3 ein Ausführungsbeispiel eines Halbleiterschalters zur Durchführung des erfindungsgemäßen Verfahrens.

In Fig. 1 ist ein Halbleiterschalter mit einem abschaltbaren Thyristor 1 dargestellt, der auch als ein GTO(Gate-turn-off)-Thyristor bezeichnet wird. Der Thyristor ist über einen anodenseitigen Anschluß A und einen Lastwiderstand R mit dem unteren Anschluß 2 einer Spannungsquelle 3 verbunden, deren oberer Anschluß 4 auf Massepotential liegt. Der kathodenseitige Anschluß K des Thyristors ist über die Kathodenzuleitung 5, in die die Schaltstrecke eines ersten Schalttransistors Tr1 eingefügt ist, mit einem Anschluß K¹ verbunden, der ebenfalls mit Massepotential beschaltet ist. Die Steuerelektrode des Thyristors 1 ist über eine Leitung 6 mit dem Anschluß 7 eines Zündstromkreises verbunden, dem eine Zündspannung $U_z$ zugeführt wird. Die Leitung 6 bildet zusammen mit einer weiteren Leitung 8, in die die Schaltstrekke eines zweiten Schalttransistors Tr2 eingefügt ist, einen Abschaltstrompfad, der die Steuerelektrode des Thyristors 1 mit dem Schaltungspunkt K' verbindet.

Tr1 und Tr2 sind zweckmäßigerweise als MIS-Feldeffekt-Schalttransistoren ausgebildet. Unter MIS-Halbleiterstrukturen werden dabei solche verstanden, die jeweils aus einer insbesondere metallischen Elektrode, einer elektrisch isolierenden Schicht und einem Halbleiterkörper bestehen. Tr1 ist mit einer seinem Gate zugeführten Steuerspannung U1 beschaltet, Tr2 mit einer Steuerspannung U2.

Fig. 2 zeigt die Zeitabhängigkeiten der Spannungen, die zweckmäßigerweise zum Betrieb des in Fig. 1 dargsstellten Halbleiterschalters herangezogen werden. In einem ersten Zeitabschnitt T1 befindet sich der Thyristor 1 in seinem blockierten Zustand. Die Steuerspannung U1, die etwa 5V beträgt, liegt am Gate des Schalttransistors Tr1, so daß dieser leitet. Gleichzeitig liegt U2 mit etwa 5V am Gate des Schalttransistors Tr2. Über Tr2 besteht eine leitende Verbindung zwischen der Steuerelektrode von 1 und dem Punkt K'. Diese Verbindung bildet einen Emitter Basis-Kurzschluß zwischen der von der Steuerelektrode kontaktierten p-Basis und dem von der kathodenseitigen Elektrode kontaktierten n-Emitter, durch der den pn-Übergang zwischen diesen Halbleitergebieten niederohmig überbrückt wird. Hierdurch wird gewährleistet, daß die von der Spannungsquelle 3 gelieferte Spannung U, die bei A und K anliegt und den Thyristor 1 in Durchlaßrichtung polt, auch beim Erreichen hoher Spannungsanstiegsgeschwindigkeiten dU/dt keine unbeabsichtigte Zündung des Thyristors herbeiführen kann.

Im Zeitabschnitt T2 wird U2 abgeschaltet, so daß Tr2 sperrt, und dem Anschluß 7 eine impulsförmige Zündspannung $U_z$ zugeführt, die einen Zündstromimpuls $I_z$ bewirkt, der über die Leitung 6, die Steuerelektrode von 1, K und Tr1 nach K' fließt. Der Thyristor 1 wird hierdurch gezündet und befindet sich anschließend im stromführenden Zustand (Zeitabschnitt T3). In T3 sperrt der Schalttransistor Tr2, während Tr1 leitet. Zum Abschalten des Thyristors (Zeitabschnitt T4) wird Tr1 gesperrt und Tr2 in den leitenden Zustand geschaltet. Damit wird der gesamte durch den Thyristor 1 fließende Laststrom in den Abschaltstrompfad 6, 8, Tr2, K' umgeleitet, so daß der Thyristor rasch gelöscht wird. Da zum Abschalten lediglich ein die Gatekapazität von Tr2 aufladender Strom benötigt wird, der im Vergleich zu dem abzuschaltenden Laststrom sehr klein ist, ist die Abschaltverstärkung, die als Quotient aus dem letzteren und dem ersteren verstanden wird, sehr groß und kann Werte über 100 annehmen. An den Zeitraum T4 schließt sich in Fig. 2 eine weitere Phase an, in der der Schalttransistor Tr1 wieder leitet und der Thyristor 1 blockiert ist.

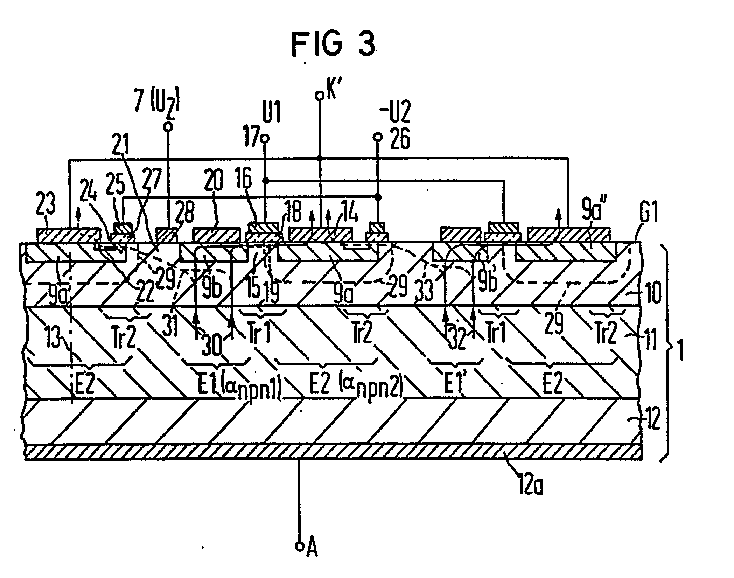

Fig. 3 zeigt den Querschnitt eines Halbleiterschalters nach der Erfindung, der in integrierter Schaltungstechnik ausgeführt ist. Gleiche Bezugzeichen in den Figuren 1 bis 3 beziehen sich dabei auf gleiche Schaltungsteile bzw. Spannungen. Wie aus Fig. 3 ersichtlich ist, weist der Thyristor 1 einen Mehrschichtenkörper aus dotiertem Halbleitermaterial, z. B. Silizium, mit einer npnp-Schichtfolge auf. Die oberste n-leitende Schicht 9a, 9a', 9a'', 9b, 9b' wird als n-Emitter bezeichnet, die angrenzende p-leitende Schicht 10 als p-Basis, die n-leitende Schicht 11 als n-Basis und die unterste, p-leitende Schicht 12 als p-Emitter. Der n-Emitter besteht aus mehreren streifenartigen Teilen 9a, 9a', 9a'', 9b und 9b', die sich bis zur Grenzfläche G1 des Halbleiterkörpers erstrecken und in dieser beispielsweise als gerade Streifenstrukturen senkrecht zur Bildebene von Fig. 3 verlaufen. In anderen Ausgestaltungen können sie innerhalb von G1 auch nach einer beliebigen Kurve, z. B. Spirale oder dergl., verlaufen, oder insbesondere eine Kreisform bzw. Ringform aufweisen. Letztere Ausgestaltung kann anhand der Fig. 3 veranschaulicht werden, wenn man die Achse 13 als eine Symmetrieachse versteht, zu der die Teile 9a, 9a', 9a'', 9b und 9b' rotationssymmetrisch angeordnet sind.

Das Teil 9a des n-Emitters wird von einer kathodenseitigen Elektrode 14 kontaktiert, die mit einem Anschluß K' versehen ist. Neben dem linken Rand von 9a ist das Teil 9b des n-Emitters so angeordnet, daß zwischen 9a und 9b eine Zone 15 der p-Basis 10 liegt, die sich bis zur Grenzfläche G1 erstreckt. Die Zone 15 wird von einem Gate 16 überdeckt, das mit einem Anschluß 17 versehen ist und durch eine dünne Isolierschicht 18 von der Grenzfläche G1 getrennt ist. Die an die Zone 15 angrenzenden Randbereiche der Teile 9a und 9b stellen die n-leitenden Source- und Draingebiete eines n-Kanal-MIS-FET dar, dessen p-leitende Kanalzone von der Zone 15 gebildet wird. Wird dem Gate 16 eine Steuerspannung U1 zugeführt, so bildet sich an der Grenzfläche G1 ein Inversionskanal 19 aus, der die Teile 9a und 9b niederohmig miteinander verbindet. Schaltet man U1 von dem Gate 16 ab, so wird der Inversionskanal 19 und damit die niederohmige Verbindung zwischen 9a und 9b beseitigt. Das Teil 9b des n-Emitters ist zweckmäßigerweise mit einer Elektrode 20 versehen, die keinen äußeren Anschluß aufweist, sondern ein Mittel darstellt, um Potentialdifferenzen innerhalb des Teils 9b im Bereich der Grenzfläche G1 auszugleichen.

Links neben dem Teil 9b ist das Teil 9a' des n-Emitters in die p-Basis 10 so eingefügt, daß eine Zone 21 der p-Basis dazwischen liegt. Im Bereich des rechten Randes des Teiles 9a' ist ein p-leitendes Gebiet 22 in dieses eingefügt, das sich bis zur Grenzfläche G1 erstreckt und in dieser von einer kathodenseitigen Elektrode 23 kontaktiert wird, die auch das Teil 9a' kontaktiert. Die Elektrode 23 ist mit dem Anschluß K' verbunden. Das Halbleitergebiet 22 und die Zone 21 stellen die p-leitenden Source- und Draingebiete eines p-Kanal-MIS-FET dar, dessen Kanalgebiet aus dem zwischen 21 und 22 liegenden Randbereich 24 des Teils 9a' besteht, wobei 24 von einem Gate 25 überdeckt wird, das mit einem Anschluß 26 versehen ist und durch eine elektrisch isolierende Schicht 27 von der Grenzfläche G1 getrennt ist. Führt man dem Anschluß 26 eine negative Steuerspannung -U2 zu, so bildet sich unterhalb von 25 an der Grenzfläche G1 ein die Teile 21 und 22 bzw. 21 und K' niederohmig miteinander verbindender Inversionskanal aus, der beim Abschalten der Spannung -U2 wieder wegfällt.

Mit 28 ist eine Steuerelektrode des Thyristors bezeichnet, die die p-Basis 10 kontaktiert und mit dem Anschluß 7 (Fig. 1) versehen ist, dem die Zündspannung $U_z$ zugeführt wird. Der p-Emitter 12 ist mit einer anodenseitigen Elektrode 12a versehen, die einen Anschluß A aufweist.

Die n-Emitterteile 9a, 9a' und 9a'' sind von Teilbereichen 29 der p-Basis 10 umgeben, die eine zusätzliche p-Dotierung aufweisen, so daß ihr Dotierungsgrad höher ist als der der übrigen Teile der p-Basis 10. Wegen des Teilbereichs 29, der das Teil 9a umgibt, hat die aus 9a, 10 uund 11 bestehende Drei-Schichten-Struktur einen Stromverstärkungsfaktor $\alpha_{npn2}$ bezüglich der vom n-Emitterteil 9a im Falle einer bei A und K' in Durchlaßrichtung des Thyristors angelegten Spannung emittierten Elektronen, der kleiner ist als der entsprechende Stromverstärkungsfaktor $\alpha_{npn1}$ der Drei-Schichten-Struktur 9b, 10 und 11 bezüglich der vom n-Emitterteil 9b unter sonst gleichen Bedingungen emittierten Elektronen. Mit Hilfe der Teilbereiche 29 wird somit erreicht, daß nach der Zündung des Thyristors, die durch eine impulsförmige positive Zündspannung $U_z$ am Anschluß 7 der Steuerelektrode 28 veranlaßt wird, der Laststrom vom p-Emitter 12 zum n-Emitterteil 9b hin verläuft, sofern der Inversionskanal 19 besteht. Dagegen findet wegen des kleineren Stromverstärkungsfaktors

$\alpha_{npn2}$ kein Stromfluß vom Emitter 12 zum n-Emitterteil 9a statt.

Bezeichnet man das n-Emitterteil 9b als Emitter E1 und die n-Emitterteile 9a und 9a' jeweils als Emitter E2, so fließt also der Laststrom bzw. ein Laststromteil, wie durch die ausgezogenen Strombahnen 30 angedeutet ist, vom D-Emitter 12 zum Emitter E1 und über den Inversionskanal 19 zu dem rechts davon liegenden Emitter E2 und weiter über die Elektrode 14 zum Anschluß K'. Schaltet man jedoch den Inversionskanal 19 unwirksam und den Inversionskanal unterhalb des Gate 25 wirksam, so wird der Laststrom bzw. Laststromteil 30 als Abschaltstrom 31 weitergeführt, und zwar nicht mehr über E1, sonder über 21, den linken Emitter E2, 22, 23 zum Anschluß K'. Hieraus geht hervor, daß der aus den Teilen 9a, 9b und 15 bis 19 bestehende FET vollständig dem Schalttransistor Tr1 von Fig. 1 entspricht, während der aus den Teilen 21, 22, 9a' und 24 bis 27 bestehende FET im wesentlichen dem Schalttransistor Tr2 von Fig. 1 entspricht, wobei als Unterschied lediglich das negative Vorzeichen der dem Anschluß 26 zuzuführenden Steuerspannung -U2 zu beachten ist. Der Laststrompfad A, K, 5, Tr1, K' von Fig. 1 entspricht dem Strompfad A, E1, 19, E2, 14 und K' von Fig. 3, während der Abschaltstrompfad 6, 8, Tr2 und K' von Fig. 1 dem Strompfad 21, E2, 22, 23 und K' von Fig. 3 entspricht.

Der auf den Emitter E1 gerichtete Laststrom bzw. Laststromteil des Thyristors wird also im Durchlaßzustand (Zeitabschnitt T3) über den rechts von E1 liegenden Emitter E2 zum Anschluß K' übertragen, während des Abschaltens (Zeitabschnitt T4) dagegen an E1 vorbei und über den links davon liegenden Emitter E2 zum Anschluß K'. Im Blockierzustand des Thyristors sind beide Schalttransistoren Tr1 und Tr2 in den leitenden Zustand geschaltet, was in Fig. 3 bedeutet, daß sowohl der Inversionskanal 19 als auch der Inversionskanal unterhalb des Gate 25 vorhanden sind. Hierdurch wird eine große Stabilität des Halbleiterschalters gegenüber unbeabsichtigten Zündvorgängen erreicht.

Neben der vorstehend beschriebenen Emitterstruktur E2, E1, E2, die die n-Emitterteile 9a', 9b und 9a enthält, zeigt Fig. 3 eine weitere, hierzu analog aufgebaute Emitterstruktur E2, E1', E2', die die Halbleitergebiete 9a, 9b' und 9a'' aufweist. Diese Emitterstruktur entspricht der erstgenannten in allen wesentlichen Schaltungsmerkmalen. Dabei sind die oberhalb von G1 angeordneten Gates und Elektroden derselben den entsprechenden Teilen der Emitterstruktur E2, E1, E2 parallel geschaltet, und zwar an den Anschlüssen 17, 26 und K'. Wegen der Analogie beider Emitterstrukturen ist am rechten Rand des n-Emitterteils 9a ein Schalttransistor Tr2 vorgesehen, der nach Aufbau und Wirkungsweise dem Schalttransistor Tr2, der aus den Teilen 21, 22, 24, 25, 26 und 27 besteht, vollständig entspricht. Bezüglich der Emitterstruktur E2, E1', E2' in Fig. 3 gilt, daß ein auf E1' gerichteter Laststromteil 32 im Zeitabschnitt T3 über den Emitter E2' zum Anschluß K' übertragen wird, dagegen im Zeitabschnitt T4 als Abschaltstrom 33 über den Emitter E2 zum Anschluß K'.

Je nach der Größe des über den Thyristor 1 zu übertragenden Laststromes können auch mehrere aus einem Emitter E1 und zwei diesen flankierenden Emittern E2 bestehende Emitterstrukturen vorgesehen sein, die auf einem gemeinsamen Halbleiterkörper integriert sind. Insbesondere können die Emitterstrukturen so ausgebildet sein, daß eine Emitterfolge E2, E1, E2, E2, E1, E2 usw. entsteht, oder die jeweils unmittelbar nebeneinanderliegenden Emitter E2 können durch einen einzigen Emitter E2 ersetzt sein, der dann entsprechend dem Emitter 9a in Fig. 3 neben einem Transistor Tr1 auch einen Transistor Tr2 aufweist.

Im Rahmen der Erfindung lassen sich unterschiedliche Stromverstärkungsfaktoren $\alpha_{npn1}$ und $\alpha_{npn2}$ auch in der Weise erreichen, daß die Teilbereiche 29 der p-Basis 10 nicht stärker dotiert werden als der übrige p-Emitter 10, sondern statt dessen mit zusätzlichen Rekombinationszentren versehen werden. Dies geschieht z. B. durch eine auf die Teilbereiche 29 beschränkte Bestrahlung der p-Basis 10 vor dem Erzeugen der n-Emitterteile 9a mit einem Elektronenstrahl. Andererseits können auch Rekombinationszentren in Form von Gold- oder Platinatomen durch Diffusion oder Implantation in die Teilbereiche 29 eingebracht werden. Die Erhöhung der Anzahl der Rekombinationszentren in den Teilbereichen 29 bewirkt eine Verringerung von $\alpha_{npn2}$ gegenüber $\alpha_{npn1}$. Die gleiche Verringerung kann dadurch erreicht werden, daß die Eindringtiefe der n-Emitterteile 9a, 9a' und 9a'' in die p-Basis 10 kleiner gewählt wird als die Eindringtiefe der n-Emitterteile 9b und 9b'.

Weiterhin kann auch anstelle des n-Emitters der p-Emitter 12 in einzelne Emitterteile aufgeteilt werden, die mit den Basisschichten 11 und 10 jeweils Drei-Schichten Strukturen mit unterschiedlichen Stromverstärkungsfaktoren $\alpha_{pnp1}$ und $\alpha_{pnp2}$ bilden und mit randseitigen Transistoren Tr1 und Tr2 versehen werden. Eine solche Ausführungsform der Erindung kann anhand der Fig. 3 erläutert werden, wenn die Leitungstypen sämtlicher Halbleitergebiete durch die jeweils entgegengesetzten ersetzt werden, die Bezeichnungen der Anschlüsse A und K' miteinander vertauscht werden und die Spannungen mit jeweils entgegengesetzten Polaritäten zugeführt werden.

**Patentansprüche**

1. Verfahren zum Betrieb eines Halbleiterschalters, der einen abschaltbaren Thyristor (1), einen ersten, mit seiner Schaltstrecke in eine Zuleitung (5) des Thyristors (1) eingefügten Schalttransistor (Tr1) und einen Abschaltstrompfad (6, 8) aufweist, der eine Steuerelektrode des Thyristors (1) mit einem auf der vom Thyristor abgewandten Seite des ersten Schalttransistors (Tr1) liegenden Anschluß (K') der Zuleitung (5) verbindet, wobei ein mit seiner Schaltstrecke in den Abschaltstrompfad (6, 8) eingefügter, zweiter Schalttransistor (Tr2) vorgesehen ist, bei dem die Zündung des Thyristors (1) mittels einer impulsförmigen Zündspannung ($U_z$) erfolgt, die der Steuerelektrode zugeführt wird, während der erste Schalttransistor (Tr1) leitet und der zweite Schalttransistor (Tr2) gesperrt wird, bei dem im Durchlaßzustand des Thyristors der erste Schalttransistor (Tr1) im leitenden Zustand und der zweite Schalttransistor (Tr2) im gesperrten Zustand betrieben werden, bei dem zum Abschalten des Thyristors der erste Schalttransistor (Tr1) gesperrt wird und der zweite Schalttransistor (Tr2) leitend geschaltet wird und bei dem im blockierten Zustand des Thyristors der zweite Schalttransistor (Tr2) im leitenden Zustand betrieben wird, dadurch gekennzeichnet, daß auch der erste Schalttransistor (Tr1) im blockierten Zustand des Thyristors (1) im leitenden Zustand betrieben wird.

2. Halbleiterschalter zur Durchführung des Verfahrens nach Anspruch 1, dadurch gekennzeichnet, daß der Thyristor (1) einen Halbleiterkörper aufweist, der einen mehrteiligen n(p)-Emitter mit einer angrenzenden p(n)-Basis und einen von einer anodenseitigen (kathodenseitigen) Elektrode kontaktierten p(n)-Emitter mit einer angrenzenden n(p)-Basis enthält, die ihrerseits an die p(n)-Basis angrenzt, daß ein erstes n(p)-Emitterteil (9b) von zwei im Abstand zu diesem angeordneten, zweiten n(p)-Emitterteilen (9a, 9a') flankiert wird, daß jedes dieser zweiten n(p)-Emitterteile (9a, 9a') mit einer kathodenseitigen (anodenseitigen) Elektrode (14, 23) kontaktiert ist, daß Randbereiche des ersten n(p)-Emitterteils (9b) und des ersten der zweiten n(p)-Emitterteile (9a) zusammen mit einem diese Randbereiche trennenden Teil der p(n)-Basis (15), der von einem durch eine elektrisch isolierende Schicht (18) von einer Grenzfläche (G1) des Halbleiterkörpers getrennte GAte (16) überdeckt ist, den ersten Schalttransistor (Tr1) bilden, und daß eine den ersten n(p)-Emitterteil (9b) von dem zweiten der zweiten n(p)-Emitterteile (9a') trennende Zone (21) des p(n)-Emitters (10) über einen an der Grenzfläche (g1) in den Halbleiterkörper integrierten Feldeffekttransistor (9a, 21, 24 bis 27), der den zweiten Schalttransistor (Tr2) bildet, mit der das zweite der zweiten n(p)-Emitterteile (9a') kontaktierenden Elektrode (23) verbunden ist.

3. Halbleiterschalter nach Anspruch 2, dadurch gekennzeichnet, daß mehrere erste n(p)-Emitterteile (9b) auf dem Halbleiterkörper vorgesehen sind, die jeweils von zwei zweiten n(p)-Emitterteilen (9a', 9a) flankiert werden.

4. Halbleiterschalter nach Anspruch 3, dadurch gekennzeichnet, daß zwischen zwei ersten n(p)-Emitterteilen (9b) ein zweites n(p)-Emitterteil (9a) angeordnet ist, das für das eine der ersten n(p)-Emitterteile (9b) das erste der zweiten n(p)-Emitterteile und für das andere der ersten n(p)-Emitterteile (9b') das zweite der zweiten n(p)-Emitterteile darstellt.

5. Halbleiterschalter nach einem der Ansprüche 2 bis 4, dadurch gekennzeichnet, daß jedes erste n(p)-Emitterteil (9b) mit der p(n)-Basis (10) und der n(p)-Basis (11) eine Drei-Schichten-Struktur bildet, deren Stromverstärkungsfaktor ($\alpha_{npn1}$) für die von dem ersten n(p)-Emitterteil (9b) emittierten Ladungsträger größer ist als der entsprechende Stromverstärkungsfaktor ($\alpha_{npn2}$) der Drei-Schichten-Struktur, die aus jedem der zweiten n(p)-Emitterteil (9a), der p(n)-Basis (10) und der n(p)-Basis (11) gebildet wird.

6. Halbleiterschalter nach Anspruch 5, dadurch gekennzeichnet, daß die Eindringtiefe eines ersten n(p)-Emitterteils (9b) in die p(n)-Basis (10) größer ist als die Eindringtiefe eines zweiten n(p)-Emitterteils (9a).

7. Halbleiterschalter nach Anspruch 5, dadurch gekennzeichnet, daß ein zweites n(p)-Emitterteil (9a) von einem Teilbereich (29) der p(n)-Basis (10) umgeben ist, dessen Dotierungsgrad höher ist als der Dotierungsgrad des Teilbereiches der p(n)-Basis (10), der ein erstes n(p)-Emitterteil (9b) umgibt.

8. Halbleiterschalter nach Anspruch 5, dadurch gekennzeichnet, daß ein zweites n(p)-Emitterteil (9a) von einem Teilbereich (29) der p(n)-Basis (10) umgeben ist, der eine größere Anzahl von Rekombinationszentren pro Raumeinheit aufweist als der Teilbereich der p(n)-Basis (10), der ein erstes n(p)-Emitterteil (9b) umgibt.

## Claims

1. A method of operating a semiconductor switch, which comprises a thyristor (1) which can be switched-off, a first switching transistor (Tr1), the switching path of which is connected into a supply line (5) of the thyristor (1), and a switch-off current path (6, 8) whith connects a control electrode of the thyristor (1) to a terminal (K') of the supply line (5), located on that side of the first switching transistor (Tr1) remote from the thyristor, where a second switching transistor (Tr2) is provided, the switchiing path of which is connected in the switch-off current path (6, 8), where the ignition of the thyristor (1) is effected by means of a pulsed ignition voltage ($U_z$) which is supplied to the control electrode, whilst the first switching transistor (Tr1) is conductive and the second switching transistor (Tr2) is blocked, where, when the thyristor is conductive, the first switching transistor (Tr1) is in the conductive state and the second switching transistor (Tr2) is in the blocked state, where, in order to switch-off the thyristor, the first switching transistor (Tr1) is blocked and the second switching transistor (Tr2) is rendered conductive, whereby when the thyristor is in the blocked state, the second switching transistor (Tr2) is in the conductive state, characterised in that the first switching transistor (Tr1) is also in the conductive state when the thyristor (1) is in the blocked state.

2. A semiconductor switch for carrying out the method claimed in Claim 1, characterised in that the thyristor (1) comprises a semiconductor body which contains a multi-part n(p)-emitter which has an adjoining p(n)-base and a p(n)-emitter which is contacted by an anode-side (cathode-side) electrode, with an adjoining n(p)-base, which itself adjoins the p(n)-base; that a first n(p)-emitter part (9b) is flanked by two second n(p)-emitter parts (9a, 9a') spaced from the first part; that each of these second n(p)-emitter parts (9a, 9a') is contacted by a cathode-side (anode-side) electrode (14, 23); that edge zones of the first n(p)-emitter part (9b) and of the first of the second n(p)-emitter parts (9a), together with a part of the p(n)-base (15) which separates these edge zones and which is covered by a gate (16) separated from a boundary surface (G1) of the semiconductor body by an electrically insulating layer (18), form the first switching transistor (Tr1); and that a zone (21) of the p(n)-emitter (10), which separates the first n(p)-emitter part (9b) from the second of the second n(p)-emitter parts (9a'), is connected to the electrode (23) which contacts the second of the second n(p)-emitter parts (9a'), through a field effect transistor (9a, 21, 24 to 27) which is integrated into the semiconductor body at the boundary surface (g1) and which forms the second switching transistor (Tr2).

3. A semiconductor switch as claimed in Claim 2, characterised in that a plurality of first n(p)-emitter parts (9b) is provided on the semiconductor body, each being flanked by two second n(p)-emitter parts (9a', 9a).

4. A semiconductor switch as claimed in Claim 3, characterised in that between two first n(p)-emitter parts (9b), a second n(p)-emitter part (9a) is arranged which, for the first of the first n(p)-emitter parts (9b), represents the first of the second n(p)-emitter parts, and which, for the other of the first n(p)-emitter parts (9b'), represents the second of the second n(p)-emitter parts.

5. A semiconductor switch as claimed in one of Claims 2 to 4, characterised in that each first n(p)-emitter part (9b) forms, together with the p(n)-base (10) and the n(p)-base (11), a three-layer structure whose current amplification factor ($\alpha_{npn1}$) for the charge carriers emitted by the first n(p)-emitter part (9b) is greater than the corresponding current amplification factor ($\alpha_{npn2}$) of the three-layer structure which is formed by the second n(p)-emitter part (9a), the p(n)-base (10) and the n(p)-base (11).

6. A semiconductor switch as claimed in Claim 5, characterised in that the penetration depth of a first n(p)-emitter part (9b) into the p(n)-base (10) is greater than the penetration depth of a second n(p)-emitter part (9a).

7. A semiconductor switch as claimed in Claim 5, <u>characterised in</u> that a second n(p)-emitter part (9a) is surrounded by a sub-zone (23) of the p(n)-base (10), the doping level of which is higher than the doping level of that sub-zone of the p(n)-base (10) which surrounds a first n(p)-emitter part (9b).

8. A semiconductor switch as claimed in Claim 5, <u>characterised in</u> that a second n(p)-emitter part (9a) is surrounded by a sub-zone (23) of the p(n)-base (10) which has a larger number of recombination centres per unit of volume than that sub-zone of the p(n)-base (10) which surrounds a first n(p)-emitter part (9b).

**Revendications**

1. Procédé pour faire fonctionner un interrupteur è semiconducteurs, qui comporte un thyristor (1) commandé par la gâchette, un premier transistor de commutation (Tr1) inséré par sa voie de commutation dans une ligne d'alimentation (5) du thyristor (1), et une voie de courant de blocage (6,8), qui relie une électrode de commande du thyristor (1) à une borne (K') de la ligne d'alimentation (5), qui est raccordée au côté, situé à l'opposé du thyristor, du premier transistor de commutation (Tr1), un second transistor de commutation (Tr2) étant inséré par sa voie de commutation dans la voie de courant de blocage (6,8), et selon lequel l'amorçage du thyristor (1) s'effectue à l'aide d'une tension impulsionnelle d'amorçage ($U_z$), qui est envoyée à l'électrode de commande pendant que le premier transistor de commutation (Tr1) est conducteur et que le second transistor de commutation (Tr2) est bloqué, et selon lequel lorsque le thyristor est à l'état passant, le premier transistor de commutation (Tr1) est à l'état conducteur et le second transistor de commutation (Tr2) est à l'état bloqué, et selon lequel, pour le blocage du thyristor, on bloque le premier transistor de commutation (Tr1) et on place à l'état conducteur le second transistor de commutation (Tr2), et selon lequel lorsque le thyristor fonction à l'état bloqué, le second transistor de commutation (Tr2) est à l'état conducteur, caractérisé par le fait que le premier transistor de commutation (Tr1) fonctionne également à l'état conducteur lorsque le thyristor (1) est à l'état bloqué.

2. Interrupteur à semiconducteurs pour la mise en oeuvre du procédé suivant la revendication 1, caractérisé par le fait que le thyristor (1) comporte un corps semiconducteur, qui possède un émetteur multiple de type n (p), que jouxte une base de type p (n), et un émetteur de type p (n), qui est en contact avec une électrode située du côté de l'anode (située du côté de la cathode) et que jouxte une base de type n (p), qui pour sa part jouxte la base de type p (n), qu'une première partie (9b) de l'émetteur de type n(p) est flanquée de deux secondes parties (9a, 9a') de l'émetteur de type n(p), disposées à distance de la première partie de l'émetteur, que chacune de ces secondes parties (9a,9a') de l'émetteur de type n(p) est en contact avec une électrode (14,23) située du côté de la cathode (située du côté de l'anode), que les zones marginales de la première partie (9b) de l'émetteur de type n(p) et de la première des secondes parties (9a) de l'émetteur de type n(p), forment, de concert avec une partie, séparant ces zones marginales, de la base (15) de type p(n) qui est recouverte par une porte (16) séparée de la surface limite (G) du corps semiconducteur par une couche électriquement isolante (18), le premier transistor de commutation (Tr1) et qu'une zone (21) de l'émetteur (10) de type p(n), qui sépare la première partie (9b) de l'émetteur de type n(p) de la deuxième des secondes parties (9a') de l'émetteur de type n(p), est reliée par l'intermédiaire d'un transistor à effet de champ (9a,21,24 à 27), qui est intégré au niveau de la surface limite (g1) dans le corps semiconducteur et forme le second transistor de commutation (Tr1), à l'électrode (23) qui est en contact avec la deuxième des secondes parties (9a') de l'émetteur de type n(p).

3. Interrupteur à semiconducteurs suivant la revendication 2, caractérisé par le fait qu'il est prévu, sur le corps semiconducteur, plusieurs premières parties (9b) de l'émetteur de type n(p), qui sont flanquées respectivement par deux secondes parties (9a',9a) de l'émetteur du type n(p).

4. Interrupteur à semiconducteurs suivant la revendication 3, caractérisé par le fait qu'entre les deux premières parties (9b) de l'émetteur de type n(p) se trouve disposée une seconde partie (9a) de l'émetteur de type n(p), qui représente, pour l'une des premières parties (9b) de l'émetteur de type n(p), la première des secondes parties de l'émetteur de type n(p), et pour l'autre des premières parties (9b') de l'émetteur de type n(p), la deuxième des secondes parties de l'émetteur de type n(p).

5. Interrupteur à semiconducteurs suivant l'une des revendications 2 à 4, caractérisé par le fait que chaque première partie (9b) de l'émetteur de type n(p) forme, avec la base (10) de type p(n) et avec la base (11) dem type n(p), une structure à trois couches, dont le facteur d'amplification de courant ($\alpha_{npn1}$) pour les porteurs de charges émis par la première partie (9b) de l'émetteur de type n(p) est supérieur au facteur d'amplification de courant correspondant ($\alpha_{npn2}$) de la structure à trois couches, qui est formée par chacune de la seconde partie (9b) de l'émetteur de type n(p), la base (10) de type p(n) et la base (11) de type n(p).

6. Interrupteur à semiconducteurs suivant la revendication 5, caractérisé par le fait que la profondeur de pénétration de la première partie (9b) de l'émetteur de type n(p) dans la base (10) de type p(n) est supérieure à la profondeur de pénétration d'une seconde partie (9a) de l'émetteur de type n(p).

7. Interrupteur à semiconducteurs suivant la

**0 106 059**

revendication 5, caractérisé par le fait qu'une seconde partie (9a) de l'émetteur de type n(p) est entourée par une zone partielle (29) de la base (10) de type p(n), dont le degré de dopage est supérieur au degré de dopage de la zone partielle de la base (10) de type p(n), qui entoure une première partie (9b) de l'émetteur de type n(p).

8. Interrupteur à semiconducteurs suivant la revendication 5, caractérisé par le fait qu'une seconde partie (9a) de l'émetteur de type n(p) est entourée par une première zone partielle (29) de la base (10) de type p(n), qui comporte un nombre de centres de recombinaison par unité d'espace, plus important que la zone partielle (10) de type p(n), qui entoure une première partie (9b) de l'émetteur de type n(p).

# FIG 1

# FIG 2

# FIG 3